# EUROPÄISCHE PATENTSCHRIFT

(11) **EP 0 994 642 B1**
(45) Veröffentlichungstag und Bekanntmachung des Hinweises auf die Patenterteilung: **23.04.2003**
(21) Anmeldenummer: 99810770.0
(22) Anmeldetag: 26.08.1999
(51) Int. Cl.: H05K 5/00

(54) **Isolierstoffgehäuse für eine auf Hochspannungspotential befindliche Baugruppe**
Insulating housing for an assembly under high voltage
Boîtier en matière isolante pour un bloc de composants portant une haute tension

(30) Priorität: 09.09.1998 DE 19841134
(43) Veröffentlichungstag der Anmeldung: 19.04.2000
(73) Patentinhaber: Bombardier Transportation GmbH, 13627 Berlin (DE)
(72) Erfinder: Berth, Matthias, Dr., 5400 Baden (CH)
(74) Vertreter: Thielmann, Andreas

(56) Entgegenhaltungen:
- US-A- 3 778 529

## Beschreibung

### TECHNISCHES GEBIET

Bei der Erfindung wird ausgegangen von einem Isolierstoffgehäuse für eine auf Hochspannungspotential befindliche, vorzugsweise leistungselektronische, Baugruppe mit zwei aus dem Gehäuse führbaren Stromanschlüssen. Gehäuse der vorgenannten Art werden in der Energietechnik im Hoch- und Mittelspannnungsbereich häufig eingesetzt, um auf hohem Potential befindliche elektrische Aktivteile zu halten und zu umschliessen.

### STAND DER TECHNIK

Ein Isolierstoffgehäuse der vorgenannten Art ist beispielsweise in Brown Boveri Mitt. 11-77, S. 634 beschrieben. Dieses Gehäuse ist im wesentlichen röhrenförmig ausgebildet und umschliesst eine Kontaktanordnung eines Leistungsschalters. Zwei mit der Kontaktanordnung galvanisch verbundene Stromanschlüsse sind durch die Mantelfläche und eine Stirnfläche des Gehäuses geführt. Das Gehäuse ist berührungssicher in einem verschliessbaren Metallschrank angeordnet.

### KURZE DARSTELLUNG DER ERFINDUNG

Der Erfindung, wie sie in den Patentansprüchen angegeben ist, liegt die Aufgabe zugrunde, ein Isolierstoffgehäuse für eine auf Hochspannungspotential befindliche Baugruppe anzugeben, welches sich durch einen geringen Raumbedarf auszeichnet, und welches zugleich platzsparend in ein vorgegebenes kleines Volumen einer die Baugruppe enthaltenden Anlage eingebaut werden kann.

Das erfindungsgemässe Isolierstoffgehäuse zeichnet sich dadurch aus, dass der überwiegende Teil seiner Oberfläche berührungssicher ausgebildet ist, und dass es daher auf diesem Teil der Oberfläche abgestützt in ein sehr kleines Volumen eingeschoben werden kann, dessen Wände sich auf Masse oder Erdpotential befinden. Seitlich aus dem Gehäuse geführte Stromanschlüsse können nun sehr platzsparend mit den Stromanschlüssen von Baugruppen verbunden werden, die jeweils in gleichartigen Isolierstoffgehäusen angeordnet sind und/oder an einen ins Innere des kleinen Volumens geführten Hochspannungs- oder Erdungsleiter einer die Baugruppen enthaltenden Anlage angeschlossen werden.

Ein sehr kompaktes und dielektrisch besonders vorteilhaftes Isolierstoffgehäuse wird erreicht, wenn nicht nur die Gehäusegeometrie optimal gestaltet ist, sondern wenn zugleich auch dielektrisch geeignet bemessene Werkstoffe eingesetzt werden, und wenn kritische Bereiche, wie der Übergang von der auf Masse oder Erdpotential liegenden Gehäuseoberfläche auf die dielektrisch hoch belasteten Seitenflächen, durch geeignet ausgebildete und angeordnete Feldsteuermittel dielektrisch entlastet werden.

### KURZE BESCHREIBUNG DER ZEICHNUNG

Ein bevorzugtes Ausführungsbeispiel der Erfindung und die damit erzielbaren weiteren Vorteile werden nachfolgend anhand von Zeichnungen näher erläutert. Hierbei zeigt:
- Fig.1: ein Blockschaltbild des Antriebs eines Schienenfahrzeugs mit einer modular aufgebauten Schaltungsanordnung,
- Fig.2: eine perspektivische Ansicht der stark vereinfacht dargestellten Schaltungsanordnung gemäss Fig.1,
- Fig.3: eine Aufsicht auf ein erfindungsgemässes Isolierstoffgehäuse eines Moduls M₂ der Schaltungsanordnung nach den Figuren 1 und 2, welches längs einer aus Fig.4 ersichtlichen Linie III - III geschnitten ist,
- Fig.4: eine Seitenansicht des längs der Linie IV - IV geschnittenen Gehäuses nach Fig.3, bei der ein nicht geschnittener Teil des Gehäuses geringfügig vergrössert dargestellt ist,
- Fig.5: eine Ansicht von links auf das längs der Linie V - V geschnittene Isolierstoffgehäuse nach Fig.3,
- Fig.6: in vergrösserter Darstellung ein Teil des Gehäuses gemäss Fig.4,
- Fig.7: in vergrösserter Darstellung ein in Fig.3 umrandet dargestellter Abschnitt des Isolierstoffgehäuses, und
- Fig.8: ein Diagramm, in dem die Verteilung der am Isolierstoffgehäuseabschnitt gemäss Fig.7 wirkenden elektrischen Feldstärke längs einer Testlinie dargestellt ist.

### WEGE ZUR AUSFÜHRUNG DER ERFINDUNG

In allen Figuren beziehen sich gleiche Bezugszeichen auf gleichwirkende Teile. Der als Blockschaltbild dargestellte Antrieb für ein Schienenfahrzeug enthält einen an eine Hochspannungsleitung von beispielsweise 15 bzw. 25 kV Wechselspannung führbaren Stromabnehmer 1, der über eine Eingangsdrosselspule 2 mit einem auf Hochspannungspotential befindlichen ersten Eingang einer Schaltungsanordnung 3 verbunden ist. Ein zweiter Eingang der Schaltungsanordnung 3 ist mit Erdpotential oder Masse verbunden. Die Schaltungsanordnung 3 ist aus n (n= 2, 3, ...) in Reihe geschalteten, jeweils eine galvanische Trennstelle aufweisenden, leistungselektronischen Modulen M₁, M₂,...Mₙ aufgebaut, von denen das Modul M₁ an Hochspannungspotential und das Modul Mₙ an Masse oder Erdpotential geführt ist. Die Module sind identisch aufgebaut und weisen jeweils eine von einem Isolierstoffgehäuse umschlossene, als Stromrichtersystem ausgebildete Leistungselektronik auf sowie zwei Eingänge, von denen ein erster mit dem in der Reihenschaltung vorgeschalteten und ein zweiter mit dem in der Reihenschaltung nachgeschalteten Modul verbunden ist. Abweichend davon ist beim Modul M₁ der erste Eingang auf Hochspannungspotential und beim Modul Mₙ der zweite Eingang auf Erdpotential oder Masse geführt. Jedes Modul weist eine mit den beiden Eingängen verbundene leistungselektronischen Baugruppe 4 auf, einen eine galvanische Trennstelle bildenden Transformator 5 und eine dem Transformator 5 nachgeschaltete leistungselektronischen Baugruppe 6 mit zwei aus dem Modul geführten Ausgängen. Die Ausgänge liegen parallel und sind über m (m=1, 2,...) Stromrichtersysteme 7 mit m Antrieben 8 verbunden.

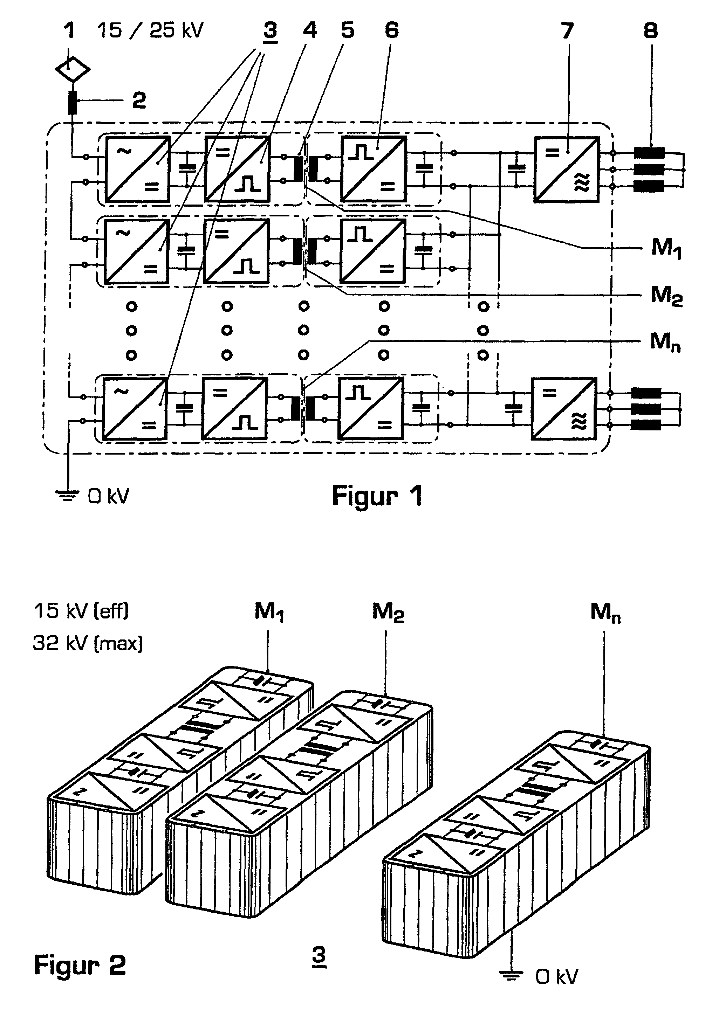

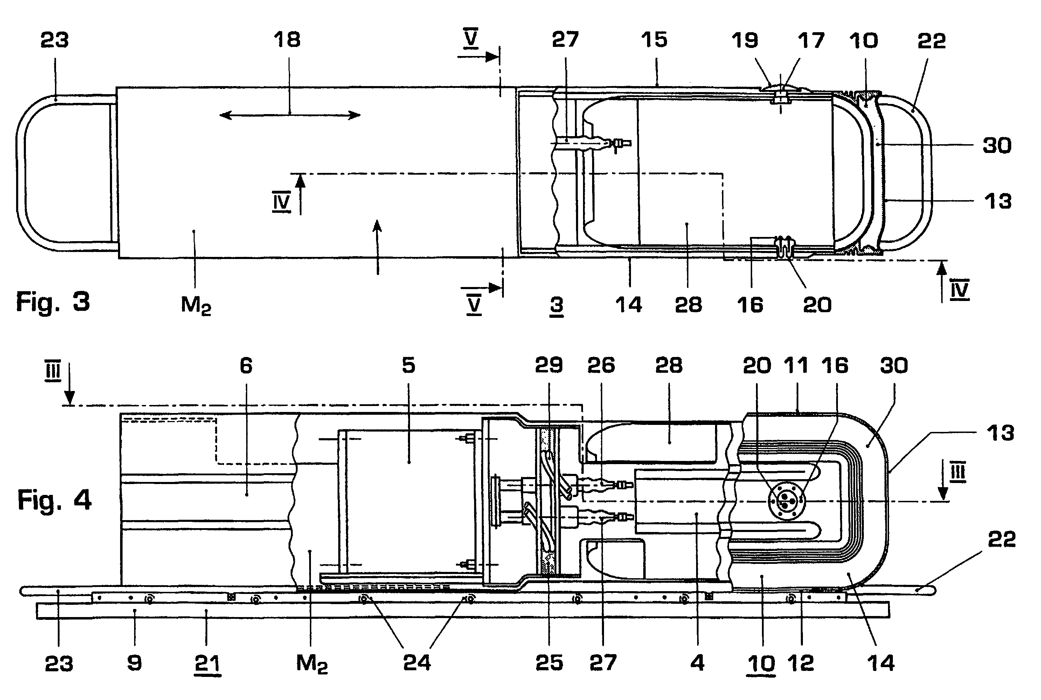

Wie aus den Fig.2 bis 6 ersichtlich ist, sind die Module im wesentlichen quaderförmig ausgebildet und sind zueinander parallel und im Vergleich zu ihrer Höhe mit geringem Abstand voneinander auf einer auf Masse oder Erdpotential befindlichen Platte 9 (Fig.4) angeordnet. Die Module weisen jeweils ein vorwiegend quaderförmig ausgebildetes Isolierstoffgehäuse 10 auf. Auf ihrer Deck- 11 und Bodenfläche 12 sowie ihrer nach vorne abgeschlossenen Frontseite 13 enthalten die Isolierstoffgehäuse 10 jeweils eine auf Masse oder Erdpotential führbare elektrisch leitende Schicht. In überwiegend eben ausgeführten Abschnitten der die beiden Seitenflächen 4, 15 des Gehäuses 10 bildenden Gehäusewand ist jeweils eine Öffnung für einen Stromanschluss der auf Hochspannungspotential befindlichen leistungselektronischen Baugruppe 4 vorgesehen. Die Stromanschlüsse benachbarter Module, z.B. M₁ und M₂, sind mit Kontakten 16, 17 einer die Reihenschaltung der Module bewirkenden Kontaktanordnung verbunden.

Die Module M₁, M₂,.... sind jeweils senkrecht zur Frontseite 13 des Isolierstoffgehäuses 10 auf der Platte 9 verschiebbar gelagert. Die Kontaktanordnung ist durch gegenseitiges Verschieben zweier benachbarter Module betätigbar. Einer der beiden Kontakte 16, 17 der Kontaktanordnung, nämlich der Kontakt 17, weist eine schräg zur Schubrichtung (Doppelpfeil 18 in Fig.3) ausgerichtete Führungsfläche 19 auf, die beim Verschieben mit dem Gegenkontakt 16 zusammenwirkt und je nach Schubrichtung des Moduls in oder ausser Eingriff mit federnd gelagerten Stiften 20 des Gegenkontakts 16 kommt.

Aus Fig.4 ist ersichtlich, dass an der Bodenfläche des Moduls M₂ ein schlittenförmiges, im wesentlichen rechteckiges Führungselement 21 mit Handgriffen 22, 23 angebracht ist. Dieses Führungselement weist an seinen als Kufen wirkenden Längsseiten Rollen 24 auf, welche auf zwei nicht dargestellten, in die Platte 9 eingeformten Schienen geführt sind. An der Front- 13 und/oder der Rückseite des Isolierstoffgehäuses 10 überragen die Handgriffe das Isolierstoffgehäuse 10.

Aus den Figuren 4 bis 6 kann ferner entnommen werden, dass der Transformator 5 und die leistungselektronische Baugruppe 6 im Isolierstoffgehäuse angeordnet sind, und dass das Isolierstoffgehäuse 10 ferner eine isolierende Zwischenwand 25 aufnimmt, welche die im rechten Teil des Isolierstoffgehäuses 10 angeordnete leistungselektronischen Baugruppe 4 vom Transformator 5 und der zweiten leistungselektronischen Baugruppe 6 trennt. Durch die Zwischenwand 25 sind die auf Hochspannungspotential befindlichen Stromanschlüsse des Transformators 5 geführt. Vorzugsweise sind die durch die Zwischenwand 25 geführten Stromanschlüsse jeweils nach Art eines Kabelendverschlusses 26, 27 ausgeführt. Hierdurch werden mit einfachen Mitteln am Übergang von der auf Hochspannungspotential befindlichen leistungselektronischen Baugruppe 4 auf die auf niedrigerem Potential befindliche leistungselektronische Baugruppe 6 vorteilhafte dielektrische Eigenschaften, wie insbesondere grosse Durchschlagsfestigkeit und gutes Kriechstromverhalten, erreicht. Besonders günstige dielektrische Eigenschaften werden erzielt, wenn die Kabelendverschlüsse 26, 27 fest mit der Zwischenwand 25 verbunden sind und in einen durch eine kappenförmige Steuerelektrode 28 abgeschirmten, die leistungselektronische Baugruppe 4 aufnehmenden Raum des Isolierstoffgehäuses 10 ragen. Durch Abstimmung der Gestalt der Steuerelektrode 28 an die Anordnung und die Ausbildung der Kabelendverschlüsse 26, 27 werden das dielektrische Verhalten des Moduls zusätzlich verbessert.

Zur Erhöhung der übertragenen Leistung sind in die isolierende Zwischenwand 25 Kühlkanäle 29 eingeformt, durch welche der Kühlung der leistungselektronischen Baugruppen 4, 6 und des Transformators 5 dienendes Kühlmittel geführt ist. Dieses Kühlmittel ist mit Vorteil eine Flüssigkeit, beispielsweise Wasser, welches durch Schläuche geleitet wird, die in den Kühlkanälen 29 verlegt sind.

Aus fertigungstechnischen Gründen zu bevorzugen ist eine Ausführungsform des Moduls M₂, bei dem die leistungselektronischen Baugruppen 4 und 6 sowie der Transformator 5 in das Isolierstoffgehäuse 10 eingesteckt sind. Im Wartungsfall wird das Modul dann aus der Schaltungsanordnung 3 herausgeschoben und können dann die einzelnen Baugruppen 4, 6 oder der Transformator 5 aus dem Isolierstoffgehäuse 10 rasch herausgezogen werden. Es ist jedoch auch möglich, das Isolierstoffgehäuse 10 klein zu halten und lediglich die leistungselektronischen Baugruppe 4 und die als Kabelendverschlüsse 26, 27 ausgebildeten Stromanschlüsse des Transformators 5 im Isolierstoffgehäuse 10 anzuordnen.

Wie aus Fig.3 entnommen werden kann, weist das Isolierstoffgehäuse 10 an der Frontseite einen Wandabschnitt 30 auf, welcher gegenüber der Wandstärke des Isolierstoffgehäuses im Bereich der Seitenflächen 14, 15 besonders dick ausgeführt ist. Dieser Abschnitt 30 ist im wesentlichen U-förmig ausgebildet und erstreckt sich von der Deckfläche 11 über die Frontseite 13 auf die Bodenfläche 12. Der U-förmige Abschnitt 30 stellt die elektrische Isolation zwischen der auf Hochspannungspotential führbaren leistungselektronischen Baugruppe 4 und den mit Masse oder Erdpotential beaufschlagbaren und mit elektrisch leitenden Schichten versehenen Aussenflächen, nämlich Deckfläche 11, Frontseite 13 und Bodenfläche 12, des Isolierstoffgehäuses 10 sicher. Der U-förmige Wandabschnitt 30 des Isolierstoffgehäuses weist eine geringere elektrische Kapazität pro Flächeneinheit auf als dessen die Seitenflächen 14, 15 bildenden Wandabschnitte.

Der U-förmige Wandabschnitt 30 enthält einen Werkstoff mit einer geringeren Dielektrizitätskonstanten als der die Seitenflächen 14, 15 bildende Werkstoff des Isolierstoffgehäuses 10. Der Werkstoff des U-förmigen Wandabschnitts 30 weist mit Vorteil Porenstruktur auf und ist vorzugsweise als Schaumstoff oder hohlkugelgefüllter Kunststoff ausgeführt. Mit einem solchen Werkstoff lassen sich Dielektrizitätskonstanten von ca. 2 erzielen. Ein Werkstoff mit geringer Dielektrizitätskonstante und zusätzlich hoher mechanischer Festigkeit kann Sandwichstruktur aufweisen mit einer die Aussen- und einer die Innenfläche des Wandabschnitts bildenden Schicht jeweils aus einem mechanisch hochwertigen Isoliermaterial, beispielsweise einem Laminat etwa auf der Basis Epoxy und Glasfaser, und einer dazwischen angeordneten dickeren Schicht aus einem Werkstoff mit geringer Dielektrizitätskonstanten, beispielsweise Schaumstoff oder hohlkörpergefüllter Kunststoff. Das hierbei verwendete Laminat bildet auch die Seitenflächen 14, 15 und weist eine Dielektrizitätskonstante von mindestens vier auf, wohingegen die Dielektrizitätskonstante des Werkstoffs mit Sandwichstruktur einen mittleren Wert von etwas mehr als 2 aufweist.

Zur Verbesserung der Isolation ist zwischen der Baugruppe 4 und dem U-förmigen Wandabschnitt 30 die kappenförmige Steuerelektrode 28 angeordnet. Diese Steuerelektrode ist mit Abstand zum Wandabschnitt 30 angeordnet und zwar so, dass der Abstand von der Frontseite 13 des Isolierstoffgehäuses 10 zur vom Transformator gebildeten galvanischen Trennstelle hin zunimmt. Hierdurch wird das elektrische Feld zwischen Hochspannungspotential und Masse bzw. Erdpotential besonders gut homogenisiert und werden dielektrisch ungünstige Feldüberhöhungen weitgehend vermieden. Die Steuerelektrode 28 besteht mit Vorteil aus elektrisch leitendem Kunststoff und weist auf ihrer Innenseite eine metallische Beschichtung auf. Zusammen mit der auf der Deckfläche 11, der Frontseite 13 und der Bodenfläche 12 angebrachten metallischen Beschichtung des U-förmigen Wandabschnitts 30 lässt sich so das elektrische Feld des Moduls M₂ besonders gut kapazitiv steuern und so äusserst vorteilhaft homogenisieren.

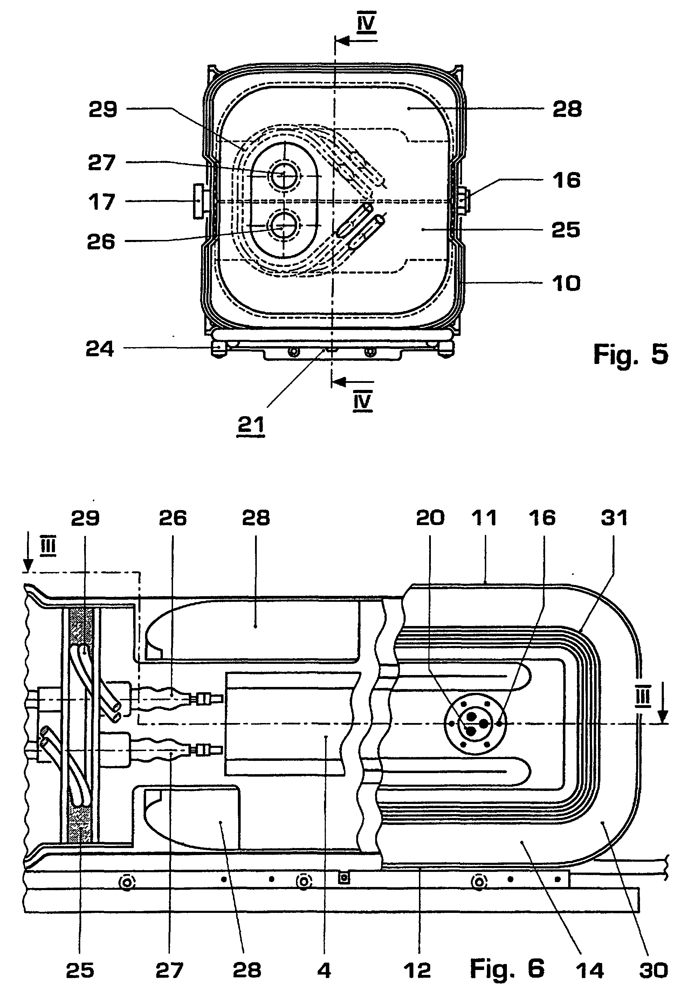

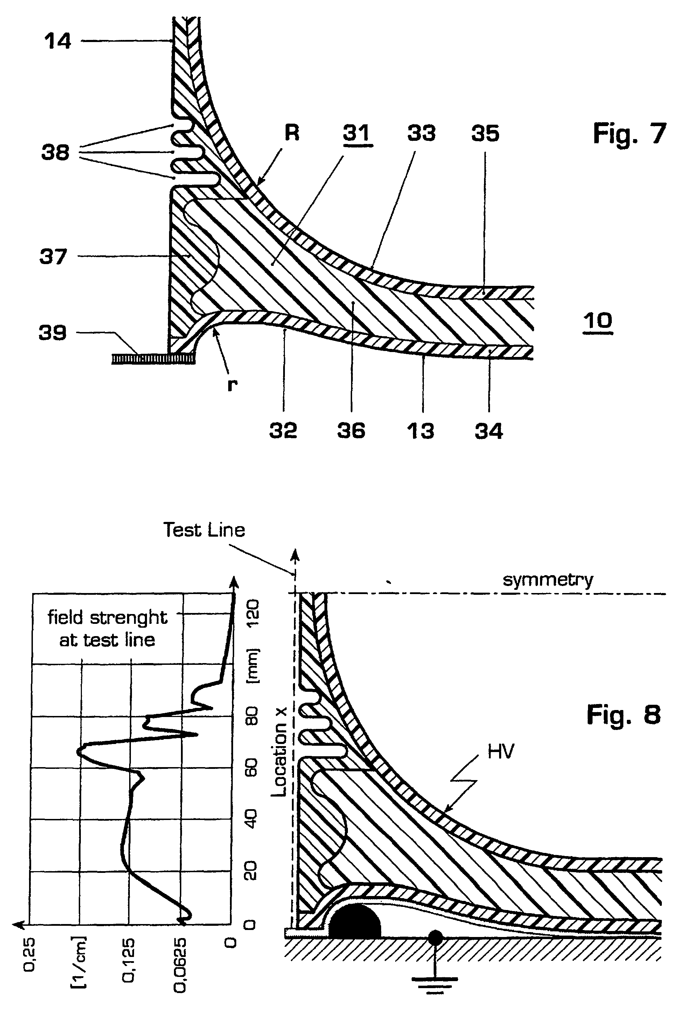

Aus Fig.7 sind die Ausbildung und die Werkstoffstruktur des Isolierstoffgehäuses 10 im dielektrisch besonders hoch beanspruchten Übergangsbereich von der Frontseite 13 auf die Seitenfläche 14 dargestellt. Dieser als Randprofil 31 ausgebildete dielektrisch hoch beanspruchte Bereich setzt sich in den an die Deck- 11 bzw. Bodenfläche 12 grenzenden Rändern der Seitenfläche 14 fort. Das dielektrisch hoch beanspruchte Randprofil 31 umgibt den in der Seitenfläche 14 vorgesehenen Kontakt 16 U-förmig (vgl. Figuren 4 und 6). Ein entsprechendes Profil ist auch an der Seitenfläche 15 vorgesehen. Das Randprofil 31 ist gewinkelt. Der in die Seitenfläche 14 erstreckte eine Schenkel des Winkels wird von dem mechanisch hochwertigen Werkstoff mit vergleichsweise grosser Dielektrizitätskonstanten gebildet. Der in die Frontseite 13, die Deckfläche 11 und die Bodenfläche 12 erstreckte Schenkel des Winkels weist Sandwichstruktur auf. Die Aussenfläche (gebildet von Frontseite 13 und Seitenfläche 14) und die Innenfläche 33 dieser Sandwichstruktur werden von Schichten 34, 35 jeweils aus dem Werkstoff mit der relativ grossen Dielektrizitätskonstanten gebildet. Eine dazwischenliegende relativ dicke Schicht 36 wird vom Werkstoff mit relativ kleiner Dielektrizitätskonstanten gebildet. Der Werkstoff der Sandwichstruktur weist so gesamthaft gegenüber dem Werkstoff in der Seitenfläche 14 eine relativ kleine Dielektrizitätskonstante auf. Durch diese Werkstoffstruktur wird die Vergleichmässigung des elektrischen Feldes auf der Oberfläche des Randprofils 31 wesentlich unterstützt.

Das Randprofil 31 weist auf seiner der leistungselektronischen Baugruppe 4 zugewandten Innenfläche 33 eine von einer elektrisch leitenden Beschichtung gebildete konkave Fläche mit einem grösseren Krümmungsradius R auf als eine auf ihrer Frontseite 13 angeordnete und gegenläufig gekrümmte, von einer elektrisch leitenden Beschichtung gebildete konkave Fläche 32 mit einem Radius r. Durch die Grössen der Radien und die gegenläufigen Krümmungen der elektrisch leitend ausgebildeten, vorzugsweise metallisierten Flächen 32, 33 wird das elektrische Feld im Randprofil 31 vergleichmässigt und wird so auf der nicht beschichteten Seitenfläche 14 das elektrische Feld noch besser verteilt.

Das Randprofil 31 weist eine U-förmig ausgebildete Wulst 37 aus dem Werkstoff der Seitenfläche 14 auf. Diese Wulst erstreckt sich vom Rand der Seitenfläche 14 in die Schicht 36 aus dem Werkstoff mit der kleinen Dielektrizitätskonstanten. Diese Wulst bewirkt zusammen mit dem Werkstoff der Schicht 36 eine zusätzliche Vergleichmässigung des elektrischen Feldes an dem auf der Seitenfläche 14 gelegenen Teil der Oberfläche des Randprofils 31. In die Seitenfläche 14 sind zusätzlich von der Wulst 37 umrandete, randparallel verlaufende Nuten 38 eingeformt. Diese Nuten bewirken zum einen eine Verringerung der elektrischen Feldstärke im Bereich der Wulst 37 und verlängern andererseits den Kriechweg entlang der Oberfläche des Randprofils 31 zwischen Masse bzw.Erdpotential und Hochspannungspotential (Kontakt 16). Der verlängerte Kriechweg ist insbesondere zur Verbesserung des Spannungsfestigkeit des Gehäuses 10 bei Verschmutzung und/oder bei Feuchtigkeit von Vorteil.

Die Wulst 37 und die Nuten 38 können in fertigungstechnisch vorteilhafter Weise in die Seitenfläche 14 eingepresst werden. An die konkave Aussenfläche 32 schliesst eine über die Seitenfläche 14 erstreckte Isolierbarriere 39 an. Diese Barriere verhindert das Starten von Oberflächenladungen, welche von Masse oder Erdpotential ausgehen.

Wie aus Fig.8 zu ersehen ist, ergibt sich im Bereich der Wulst 37 eine nahezu ortsunabhängige elektrische Feldstärke. Höhere Feldstärkespitzen treten zwar im Bereich der Nuten 38 auf. Diese Spitzen sind jedoch wegen der dort vorhandenen Luftisolierstrecken unkritisch. Die resultierenden Spannungsabfälle über den Nuten 38 reduzieren jedoch die elektrische Feldstärke längs der Oberfläche des Randprofils 31 im Bereich der Wulst 37. Ersichtlich steht an der Isolierstoffbarriere 39 eine besonders kleine elektrische Feldstärke an.

### Bezugszeichenliste

- 1: Stromabnehmer
- 2: Eingangsdrosselspule
- 3: Schaltungsanordnung
- 4: leistungselektronische Baugruppe
- 5: Transformator
- 6: leistungselektronische Baugruppe
- 7: Stromrichtersystem
- 8: Motor
- 9: Platte
- 10: Isolierstoffgehäuse
- 11: Deckfläche
- 12: Bodenfläche
- 13: Frontseite
- 14, 15: Seitenflächen
- 16, 17: Kontakte
- 18: Doppelpfeil
- 19: Führungsfläche
- 20: Stifte
- 21: Führungselement
- 22, 23: Handgriffe
- 24: Rollen
- 25: Zwischenwand
- 26, 27: Kabelendverschlüsse
- 28: Steuerelektrode
- 29: Kühlkanäle
- 30: U-förmiger Wandabschnitt
- 31: Randprofil
- 32: konkave Fläche
- 33: Innenfläche
- 34, 35, 36: Schichten
- 37: Wulst
- 38: Nuten
- 39: Isolierstoffbarriere

## Patentansprüche

1. Isolierstoffgehäuse für eine auf Hochspannungspotential befindliche, vorzugsweise leistungselektronische, Baugruppe (4) mit zwei aus dem Gehäuse führbaren Stromanschlüssen, **dadurch gekennzeichnet, dass** das Gehäuse (10) weitgehend quaderförmig ausgebildet ist und einen von seiner Deckfläche (11) über seine Frontfläche (13) auf seine Bodenfläche (12) erstreckten U-förmigen Wandabschnitt (30) aufweist, dessen Aussenfläche mit Masse oder Erdpotential und dessen Innenfläche mit dem Hochspannungspotential beaufschlagbar ist, und dass in überwiegend eben ausgeführten Abschnitten der die beiden Seitenflächen (14, 15) des Gehäuses (10) bildenden Gehäusewand jeweils eine Öffnung für einen Stromanschluss der Baugruppe (4) vorgesehen ist.

2. Gehäuse nach Anspruch 1, **dadurch gekennzeichnet, dass** der U-förmige Wandabschnitt (30) eine geringere elektrische Kapazität pro Flächeneinheit aufweist als dessen die Seitenflächen (14, 15) bildenden Wandabschnitte.

3. Gehäuse nach Anspruch 2, **dadurch gekennzeichnet, dass** die Dicke des Wandabschnitts (30) grösser ist als diejenige der Seitenflächen (14, 15).

4. Gehäuse nach einem der Ansprüche 2 oder 3, **dadurch gekennzeichnet, dass** der U-förmige Wandabschnitt (30) einen Werkstoff mit einer geringeren Dielektrizitätskonstanten enthält als die Seitenflächen (14, 15).

5. Gehäuse nach Anspruch 4, **dadurch gekennzeichnet, dass** der Werkstoff des U-förmigen Wandabschnitts (30) Porenstruktur aufweist und vorzugsweise als Schaumstoff oder als hohlkörpergefüllter Kunststoff ausgeführt ist.

6. Gehäuse nach Anspruch 4 oder 5, **dadurch gekennzeichnet, dass** der U-förmige Wandabschnitt (30) Sandwichstruktur aufweist mit einer die Aussenund einer die Innenfläche (33) des Wandabschnitts (30) bildenden Schicht (34, 35) jeweils aus einem mechanisch hochwertigen Isoliermaterial und einer dazwischen angeordneten dickeren Schicht (36) aus dem Werkstoff mit geringer Dielektrizitätskonstanten.

7. Gehäuse nach einem der Ansprüche 1 bis 6, **dadurch gekennzeichnet, dass** in den U-förmigen Wandabschnitt mindestens ein in eine der beiden Seitenflächen (14) übergehendes Randprofil (31) eingeformt ist, welches auf seiner der hochspannungsführenden leistungselektronischen Baugruppe (4) zugewandten Innenseite jeweils eine erste konkave Fläche (33) mit einem grösseren Krümmungsradius (R) aufweist als eine auf seiner Aussenseite angeordnete und gegenläufig gekrümmte zweite konkave Fläche (32).

8. Gehäuse nach Anspruch 7, **dadurch gekennzeichnet, dass** das mindestens eine Randprofil (31) eine U-förmig ausgebildete Wulst (37) aus dem Werkstoff der Seitenfläche (14, 15) aufweist, welche sich vom Rand der zugeordneten Seitenfläche (14) in den Werkstoff mit der geringeren Dielektrizitätskonstanten als der Werkstoff der Seitenflächen (14, 15) erstreckt.

9. Gehäuse nach Anspruch 8, **dadurch gekennzeichnet, dass** in die der Wulst (37) zugeordnete Seitenfläche (14) von der Wulst (37) umrandete, randparallel verlaufende Nuten (38) eingeformt sind.

10. Gehäuse nach Anspruch 9, **dadurch gekennzeichnet, dass** die Wulst (37) und die Nuten (38) in die Seitenfläche (14) eingepresst sind.

11. Gehäuse nach einem der Ansprüche 7 bis 10, **dadurch gekennzeichnet, dass** die erste und die zweite konkave Fläche (32, 33) mit einer metallischen Beschichtung versehen sind.

12. Gehäuse nach einem der Ansprüche 7 bis 11, **dadurch gekennzeichnet, dass** an die zweite konkave Fläche (32) eine die Seitenfläche (14) überragende Isolierbarriere (39) anschliesst.

## Claims

1. A housing of an insulating material for a preferably electronic module (4) that is connected to a high voltage and contains two power terminals that extend out of the housing, **characterized by** the fact that the housing (10) is realized in a largely cuboid fashion and contains a U-shaped wall section (30) that extends from its top surface (11) to its bottom surface (12) over its front surface (13), wherein the outer surface of this wall section can be connected to the ground or the ground potential and its inner surface can be connected to the high voltage, and by the fact that an opening for a power terminal of the module (4) is respectively provided in predominantly plane sections of the housing wall which form the lateral surfaces (14, 15) of the housing (10).

2. The housing according to Claim 1, **characterized by** the fact that the U-shaped wall section (30) has a lower electric capacitance per surface unit than its wall sections that form the lateral surfaces (14, 15).

3. The housing according to Claim 2, **characterized by** the fact that the thickness of the wall section (30) is greater than that of the lateral surfaces (14, 15).

4. The housing according to Claim 2 or 3, **characterized by** the fact that the U-shaped wall section (30) contains a material with a lower relative permittivity than the lateral surfaces (14, 15).

5. The housing according to Claim 4, **characterized by** the fact that the material of the U-shaped wall section (30) has a porous structure and is preferably realized in the form of a cellular material or a plastic filled with hollow parts.

6. The housing according to Claim 4 or 5, **characterized by** the fact that the U-shaped wall section (30) has a sandwich structure, wherein the layers (34, 35) that form the outer and the inner surface (33) of the wall section (30) respectively consist of a mechanically high-quality insulating material, and wherein a thicker layer (36) arranged in between consists of the material with the lower relative permittivity.

7. The housing according to one of Claims 1-6, **characterized by** the fact that at least one marginal profile (31) that transforms into one of the two lateral surfaces (14) is integrally formed into the U-shaped wall section, wherein said marginal profile has a first concave surface (33) on its inner side that faces the electronic module (4) connected to the high voltage, and wherein the curvature radius (R) of this first concave surface is greater than that of a second, oppositely curved concave surface (32) arranged on the outer side.

8. The housing according to Claim 7, **characterized by** the fact that the at least one marginal profile (31) contains a U-shaped bead (37) that consists of the material of the lateral surfaces (14, 15) and extends from the edge of the assigned lateral surface (14) into the material with the lower relative permittivity than the material of the lateral surfaces (14, 15).

9. The housing according to Claim 8, **characterized by** the fact that grooves (38) which extend parallel to the respective edge and are bordered by the bead (37) are produced in the lateral surface (14) that is assigned to the bead (37).

10. The housing according to Claim 9, **characterized by** the fact that the bead (37) and the grooves (38) are pressed into the lateral surface (14).

11. The housing according to one of Claims 7-10, **characterized by** the fact that the first and the second concave surface (32, 33) are provided with a metallic coating.

12. The housing according to one of Claims 7-11, **characterized by** the fact that an insulating barrier (39) that protrudes over the lateral surface (14) borders on the second concave surface (32).

## Revendications

1. Boîtier en matière isolante pour un composant (4) se trouvant sur un potentiel haute tension, de préférence électronique de puissance, avec deux raccords de courant partant depuis le boîtier, **caractérisé en ce que** le boîtier (10) est réalisé largement en forme de parallélépipède et présente une section de paroi (30) en forme de U s'étendant entre la surface de dessus (11) à la surface de fond (12) en passant par la surface avant (13) du boîtier, paroi dont la surface externe subit l'impact d'une masse ou d'un potentiel de terre et dont la surface interne subit l'impact d'un potentiel de haute tension et **en ce que** dans des sections principalement planes de la paroi de boîtier formant les deux surfaces latérales (14, 15) du boîtier (10), il est prévu respectivement une ouverture pour un raccordement de courant dû composant (4).

2. Boîtier selon la revendication 1, **caractérisé en ce que** la section de paroi (30) en forme de U présente une capacité électrique plus faible par unité de surface que celle de sections de paroi formant les surfaces latérales (14, 15).

3. Boîtier selon la revendication 2, **caractérisé en ce que** l'épaisseur de la section de paroi (30) est supérieure à celle des surfaces latérales (14, 15).

4. Boîtier selon l'une des revendications 2 ou 3, **caractérisé en ce que** la section de paroi en forme de U (30) comprend un matériau d'une constante diélectrique plus faible que les surfaces latérales (14, 15).

5. Boîtier selon la revendication 4, **caractérisé en ce que** le matériau des sections de paroi en forme de U (30) présente une structure de pores et de préférence est réalisé comme une substance cellulaire ou comme matière plastique aux cavités pleines.

6. Boîtier selon la revendication 4 ou 5, **caractérisé en ce que** la section de paroi en forme de U (30) présente une structure en sandwich avec une couche (34) formant la surface externe et une couche (35) formant la surface interne (33) de la section de paroi (30) respectivement à partir d'un matériau isolant de haute qualité mécanique et d'une couche (36) plus épaisse intercalée entre ces dernières et réalisée à partir d'un matériau avec une constante diélectrique plus faible.

7. Boîtier selon l'une des revendications 1 à 6, **caractérisé en ce qu'**il est moulé dans la section de paroi en forme de U au moins un profilé de bordure (31) se transformant dans l'une des deux surfaces latérales (14), profilé qui présente, sur sa face interne tournée vers le composant (4) électronique de puissance conducteur de haute tension, une première surface concave (33) avec un rayon de courbure supérieur (R) à celui d'une seconde surface concave (32) cintrée en sens inverse et disposée sur la face externe du profilé.

8. Boîtier selon la revendication 7, **caractérisé en ce qu'**au moins un profilé de bordure (31) présente un bourrelet (37) en forme de U composé du matériau de la surface latérale (14, 15), bourrelet qui s'étend depuis le bord de la surface latérale associée (14) dans le matériau avec la constante diélectrique plus faible que le matériau des surfaces latérales (14, 15).

9. Boîtier selon la revendication 8, **caractérisé en ce que** des gorges (38) s'étendant parallèlement au bord et entourées par le bourrelet (37) sont formées dans la surface latérale (14) associée au bourrelet (37).

10. Boîtier selon la revendication 9, **caractérisé en ce que** les bourrelets (37) et les gorges (38) sont pressés dans les surfaces latérales (14).

11. Boîtier selon l'une des revendications 7 à 10, **caractérisé en ce que** la première et la seconde surface concave (32, 33) sont munies d'un revêtement métallique.

12. Boîtier selon l'une des revendications 7 à 11, **caractérisé en ce que** la seconde barrière concave (32) se prolonge par une barrière isolante (39) faisant saillie de la surface latérale (14).
